(19) Europäisches Patentamt
European Patent Office
Office européen des brevets

(11) **EP 4 014 293 B1**

(12) **EUROPEAN PATENT SPECIFICATION**

(45) Date of publication and mention
of the grant of the patent:
**04.03.2026 Bulletin 2026/10**

(21) Application number: **19755349.8**

(22) Date of filing: **14.08.2019**

(51) International Patent Classification (IPC):
*H02H 3/16* (2006.01)        *B60L 3/00* (2019.01)
*G01R 27/18* (2006.01)       *G01R 31/52* (2020.01)

(52) Cooperative Patent Classification (CPC):
**H02H 3/16; B60L 53/11; B60L 53/60; G01R 31/52;**
**H02J 7/60;** G01R 27/18; G01R 31/40;
H02J 2105/37; Y02T 10/70; Y02T 10/7072;
Y02T 90/12; Y02T 90/14

(86) International application number:
**PCT/EP2019/071826**

(87) International publication number:
**WO 2021/028039 (18.02.2021 Gazette 2021/07)**

(54) **DIRECT CURRENT POWER SUPPLY ASSEMBLY PROVIDED WITH FAULT DETECTION SYSTEM**

GLEICHSTROMVERSORGUNGSANORDNUNG MIT FEHLERERKENNUNGSSYSTEM

ENSEMBLE D'ALIMENTATION EN COURANT CONTINU POURVU D'UN SYSTÈME DE DÉTECTION DE DÉFAUT

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(43) Date of publication of application:
**22.06.2022 Bulletin 2022/25**

(73) Proprietor: **ABB Schweiz AG**
**5400 Baden (CH)**

(72) Inventors:
• **REDDY, B. Dastagiri**
  **Chennai, Tamil Nadu (IN)**
• **NOISETTE, Philippe**
  **1209 Geneve (CH)**
• **WU, Tong**
  **721 83 Västerås (SE)**

(74) Representative: **Kolster Oy Ab**
**Salmisaarenaukio 1**
**P.O. Box 204**
**00181 Helsinki (FI)**

(56) References cited:
EP-A2- 0 884 817        US-A1- 2013 272 039
US-A1- 2015 381 030     US-A1- 2017 131 340
US-A1- 2019 210 481

• **LEE SANG HYUK ET AL: "Proposal of DC Ground Fault Detection and Interruption Method in the Ungrounded Photovoltaic Array", 2019 IEEE 46TH PHOTOVOLTAIC SPECIALISTS CONFERENCE (PVSC), IEEE, 16 June 2019 (2019-06-16), pages 1357 - 1362, XP033702922, DOI: 10.1109/PVSC40753.2019.8980529**

**Description**

FIELD OF THE INVENTION

The present invention relates to detection of electrical faults in connection with a direct current power supply assembly.

Direct current power supply assemblies are used for example for charging electric vehicles. In order to avoid personal injuries and material damages, direct current power supply assemblies in many cases require a fault detection system for detecting ground faults.

A known direct current power supply assembly is provided with a fault detection system which is based on an insulation measurement method. This type of fault detection system does detect an insulation fault in the assembly.

One of the problems associated with the above direct current power supply assembly is that a reaction time of the fault detection system thereof is relatively long, about 15 to 30 seconds.

Examples for a direct current power supply assembly are disclosed in the following prior art documents:

S. H. Lee and K. S. Lee, "Proposal of DC Ground Fault Detection and Interruption Method in the Ungrounded Photovoltaic Array," presented at the 2019 IEEE 46th Photovoltaic Specialists Conference (PVSC-46), Chicago, USA; DOI: 10.1109/PVSC40753.2019.8980529. The paper proposes a common-mode voltage-based ground-fault detection and interruption approach for ungrounded PV arrays, monitoring the array's midpoint potential to identify faults, and

US2013/0272039 A1, which discloses an electrical circuit with two DC-link capacitors and a measuring resistor from the capacitors' midpoint to ground; a control scheme forces equal potentials at the AC-side terminals and evaluates the transient voltage across the measuring resistor to detect ground faults.

BRIEF DESCRIPTION OF THE INVENTION

An object of the present invention is to provide a direct current power supply assembly so as to solve the above problem. The objects of the invention are achieved by a direct current power supply assembly which is characterized by what is stated in the independent claim. The preferred embodiments of the invention are disclosed in the dependent claims.

The invention is based on the idea of detecting ground faults in a direct current power supply assembly by means of common mode voltage monitoring.

An advantage of the direct current power supply assembly of the invention is that a fault detection system thereof is capable of detecting fast ground faults in the assembly. Further, the direct current power supply assembly of the invention is simple and inexpensive.

BRIEF DESCRIPTION OF THE DRAWINGS

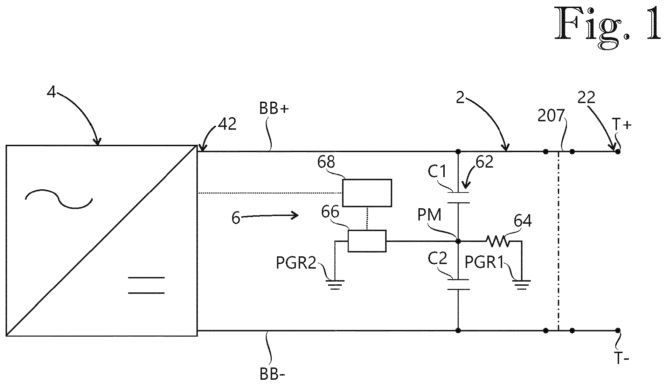

In the following the invention will be described in greater detail by means of preferred embodiments with reference to the attached Figure 1 which shows a direct current power supply assembly according to an embodiment of the invention.

DETAILED DESCRIPTION OF THE INVENTION

Figure 1 shows a direct current power supply assembly comprising a bus bar system 2, a direct current power supply system 4, and a fault detection system 6. The assembly is adapted for charging electric vehicles.

The bus bar system 2 has a positive bus bar BB+, a negative bus bar BB-, an output 22 adapted to be connected to a load of the assembly, and a bus bar switch 207. The output 22 of the bus bar system 2 comprises a plug contact having a positive load terminal T+ connected to the positive bus bar BB+, and a negative load terminal T- connected to the negative bus bar BB-. In an alternative embodiment, the output of the bus bar system comprises another type of a temporary coupling device.

The direct current power supply system 4 is adapted to supply direct current power to an output 42 thereof. The output 42 of the direct current power supply system 4 is connected to the bus bar system 2 for supplying direct current power from the direct current power supply system 4 to the bus bar system 2. The bus bar switch 207 is adapted to selectively connect the output 42 of the direct current power supply system 4 to the output 22 of the bus bar system 2, and to disconnect the output 42 of the direct current power supply system 4 from the output 22 of the bus bar system 2.

A nominal voltage of the output 42 of the direct current power supply system 4 is 400 V. In alternative embodiments, a nominal voltage of the output of the direct current power supply system is equal to or greater than 40 V.

A nominal power of the direct current power supply system 4 is 50 kVA. In alternative embodiments, a nominal power of the direct current power supply system is equal to or greater than 500 VA.

The direct current power supply system 4 comprises a rectifier having a plurality of controllable semiconductor switches. In alternative embodiments the direct current power supply system is another type of system such as a direct-current converter.

The fault detection system 6 is adapted to detect ground faults in the direct current power supply assembly. The fault detection system 6 is also adapted to detect electric arcs in the direct current power supply assembly.

The fault detection system 6 is connected between the positive bus bar BB+ and the negative bus bar BB-, and comprises a capacitor arrangement 62, a resistor arrangement 64, a voltage measuring arrangement 66, and a detector arrangement 68.

The capacitor arrangement 62 comprises a first capacitor C1 connected between the positive bus bar BB+ and a middle point PM, and a second capacitor C2 connected between the negative bus bar BB- and the middle point PM. The first capacitor C1 and the second capacitor C2 are designed the same way as capacitors of a known output filter for the rectifier of the direct current power supply system 4. The first capacitor C1 and the second capacitor C2 are identical with each other.

In an embodiment, capacitances of the first capacitor and the second capacitor are identical and in a range of $0.4 \cdot C_{vl12}$ to $2 \cdot C_{vl12}$, in which $C_{vl12}$ is calculated with an equation

$$C_{vl12} = \frac{I_{dc\_max}}{f_{rpl} \Delta V_{dc\_rpl}} \qquad ,$$

where $I_{dc\_max}$ is the maximum output current of the direct current power supply system, $f_{rpl}$ is the ripple frequency at the output of the direct current power supply system, and $\Delta V_{dc\_rpl}$ is the maximum allowable ripple in an output voltage at the output of the direct current power supply system. The resistor arrangement 64 provides a high resistance between the middle point PM and a ground potential. Resistance of the resistor arrangement 64 is 2 MΩ. In an alternative embodiment, resistance provided by the resistor arrangement between the middle point and the ground potential is equal to or greater than 1 MΩ. In a further alternative embodiment, resistance $R_{mg}$ provided by the resistor arrangement between the middle point and the ground potential is selected based on an inequality

$$R_{mg} \geq \frac{U_{dc\_nom}}{0.001 \ V/\Omega},$$

where $U_{dc\_nom}$ is a nominal value of an output voltage at the output of the direct current power supply system. Using the above inequality, the resistor arrangement 64 in the embodiment of Figure 1 should have a resistance greater than or equal to 400 kΩ, and thereby the value 2 MΩ satisfies the inequality.

The fault detection system 6 is adapted to serve as a DC voltage filter to filter out any ripple in the output 42 of the direct current power supply system 4.

The voltage measuring arrangement 66 is adapted for measuring a voltage of the middle point PM relative to the ground potential. The voltage measuring arrangement 66 comprises a voltage sensor.

In Figure 1, the resistor arrangement 64 is connected between the middle point PM and a first ground potential point PGR1 which is in the ground potential, and the voltage measuring arrangement 66 is adapted for measuring a voltage of the middle point PM relative to the ground potential by measuring a voltage between the middle point PM and a second ground potential point PGR2 which is in the ground potential. In an alternative embodiment, the resistor arrangement is connected between the middle point and a common ground potential point which is in the ground potential, and the voltage measuring arrangement is adapted for measuring a voltage of the middle point relative to the ground potential by measuring a voltage between the middle point and the common ground potential point.

In an alternative embodiment, the resistor arrangement is integrated in the voltage measuring arrangement.

The detector arrangement 68 is communicatively connected to the voltage measuring arrangement 66 and the direct current power supply system 4. The detector arrangement 68 is adapted to monitor a voltage value of the middle point PM, and to detect a fault situation if predetermined fault conditions relating to the voltage value of the middle point PM are fulfilled, the predetermined fault conditions including an absolute value of the voltage value of the middle point PM being equal to or greater than a first threshold voltage. The predetermined fault conditions further include a requirement that the absolute value of the voltage value of the middle point PM has to remain equal to or greater than the first threshold voltage for a predetermined first minimum duration.

In the assembly of Figure 1, the predetermined first minimum duration is 5 ms. In alternative embodiments, the predetermined first minimum duration is less than or equal to 5 s. In many embodiments, the predetermined first minimum duration is less than or equal to 5 ms, a typical range being from 1 ms to 5 ms. However, it is possible to use values less than 1 ms, or values in a range of 5 ms to 5 s. In still further alternative embodiments, the predetermined fault conditions include a plurality of threshold voltages, and a predetermined minimum duration for each of the plurality of threshold voltages such that the higher the threshold voltage, the shorter the corresponding predetermined minimum duration.

As a response to the detected fault situation, the detector arrangement 68 is adapted to stop supplying direct current power from the direct current power supply system 4 to the bus bar system 2.

The detector arrangement 68 is adapted to generate the voltage value of the middle point PM from an output signal of the voltage measuring arrangement 66 through signal processing, wherein the signal processing is adapted to improve quality of the fault detection by filtering the output signal of the voltage measuring arrangement 66. In an alternative embodiment, the signal processing step is carried out by the voltage measuring arrangement. In a further alternative embodiment, the voltage measuring arrangement is integrated in the detector arrangement.

In an alternative embodiment, the detector arrangement is adapted to respond to a detected fault situation by reducing supply of direct current power out of the bus bar system through controlling the direct current power supply system. In a further alternative embodiment, the detector arrangement is adapted to respond to a detected fault situation by disconnecting the direct current power supply system from the output of the bus bar system. In the embodiment of Figure 1, such disconnection could be done by opening the bus bar switch 207.

In the embodiment of Figure 1 the first threshold voltage is 20 V. Therefore, the predetermined fault conditions relating to the voltage value of the middle point PM can be fulfilled only if the voltage value of the middle point PM is +20 V or higher, or -20 V or less.

In an alternative embodiment, a ratio between the first threshold voltage and a nominal voltage of the output of the direct current power supply system is in a range of 1 - 10 %. In a further alternative embodiment, a ratio between the first threshold voltage and a nominal voltage of the output of the direct current power supply system is in a range of 4 - 6 %.

It will be obvious to a person skilled in the art that the inventive concept can be implemented in various ways. The invention and its embodiments are not limited to the examples described above but may vary within the scope of the claims.

**Claims**

1. A direct current power supply assembly comprising:

   a bus bar system (2) having a positive bus bar (BB+) and a negative bus bar (BB-), the bus bar system (2) comprising an output (22) adapted to be connected to a load of the assembly;
   a direct current power supply system (4) having an output (42) connected to the bus bar system (2);
   a fault detection system (6) adapted to detect ground faults in the direct current power supply assembly,
   a capacitor arrangement (62) comprising a first capacitor (C1) connected between the positive bus bar (BB+) and a middle point (PM), and a second capacitor (C2) connected between the negative bus bar (BB-) and the middle point (PM); the fault detection system (6) is **characterised in that** it further comprises:

   a resistor arrangement (64) providing a high resistance between the middle point (PM) and a ground potential;
   a voltage measuring arrangement (66) for measuring a voltage of the middle point (PM) relative to the ground potential; and
   a detector arrangement (68) adapted to monitor a voltage value of the middle point (PM), and to detect a fault situation if predetermined fault conditions relating to the voltage value of the middle point (PM) are fulfilled, the predetermined fault conditions including the voltage value of the middle point (PM) being equal to or greater than a first threshold voltage,
   wherein as a response to a detected fault situation, the detector arrangement (68) is adapted to at least reduce supply of direct current power out of the bus bar system (2), and
   wherein a ratio between the first threshold voltage and a nominal voltage of the output (42) of the direct current power supply system (4) is in a range of 1-10 %.

2. A direct current power supply assembly according to claim 1, **characterized in that** as a response to the detected fault situation, the detector arrangement (68) is adapted to stop supplying direct current power from the direct current power supply system (4) to the bus bar system (2).

3. A direct current power supply assembly according to claim 1 or 2, **characterized in that** as a response to the detected fault situation, the detector arrangement (68) is adapted to disconnect the direct current power supply system (4) from the output (22) of the bus bar system (2).

4. A direct current power supply assembly according to any one of preceding claims, **characterized in that** a nominal voltage of the output (42) of the direct current power supply system (4) is equal to or greater than 40 V.

5. A direct current power supply assembly any one of preceding claims, **characterized in that** the first threshold voltage is in a range of 4 - 50 V.

6. A direct current power supply assembly according to any one of preceding claims, **characterized in that** the voltage value of the middle point (PM) is generated from an output signal of the voltage measuring arrangement (66) through signal processing by the detector arrangement (68), wherein the signal processing is adapted to improve quality of the fault detection by filtering the output signal of the voltage measuring arrangement (66).

7. A direct current power supply assembly according to any one of preceding claims, **characterized in that** a value of the high resistance provided by the resistor arrangement (64) between the middle point (PM) and the ground potential fulfils an inequality

$$R_{mg} \geq \frac{U_{dc\_nom}}{0.001\,V/\Omega},$$

where $R_{mg}$ is the value of the high resistance, and $U_{dc\_nom}$ is a nominal value of an output voltage at the output (42) of the direct current power supply system (4).

8. A direct current power supply assembly according to any one of preceding claims, **characterized in that** the assembly is adapted for charging electric vehicles.

9. A direct current power supply assembly according to any one of preceding claims, **characterized in that** the output (22) of the bus bar system (2) comprises a temporary coupling device such as a plug contact.


**Patentansprüche**

1. Gleichstromleistungsversorgungsbaugruppe, die Folgendes umfasst:

   ein Sammelschienensystem (2) mit einer positiven Sammelschiene (BB+) und einer negativen Sammelschiene (BB-), wobei das Sammelschienensystem (2) einen Ausgang (22) umfasst, der dazu ausgelegt ist, mit einer Last der Baugruppe verbunden zu werden;
   ein Gleichstromleistungsversorgungssystem (4) mit einem Ausgang (42), der mit dem Sammelschienensystem (2) verbunden ist;
   ein Fehlerdetektionssystem (6), das dazu ausgelegt ist, Massefehler in der Gleichstromleistungsversorgungsbaugruppe zu detektieren, eine Kondensatoranordnung (62), die einen ersten Kondensator (C1), der zwischen die positive Sammelschiene (BB+) und einen Mittelpunkt (PM) geschaltet ist, und einen zweiten Kondensator (C2), der zwischen die negative Sammelschiene (BB-) und den Mittelpunkt (PM) geschaltet ist, umfasst; wobei das Fehlerdetektionssystem (6) **dadurch gekennzeichnet ist, dass** es ferner Folgendes umfasst:

   eine Widerstandsanordnung (64), die einen hohen Widerstand zwischen dem Mittelpunkt (PM) und einem Massepotenzial bereitstellt;
   eine Spannungsmessanordnung (66) zum Messen einer Spannung des Mittelpunkts (PM) relativ zu dem Massepotenzial; und
   eine Detektoranordnung (68), die dazu ausgelegt ist, einen Spannungswert des Mittelpunkts (PM) zu überwachen und eine Fehlersituation zu detektieren, wenn vorbestimmte Fehlerbedingungen bezüglich des Spannungswerts des Mittelpunkts (PM) erfüllt sind, wobei die vorbestimmten Fehlerbedingungen beinhalten, dass der Spannungswert des Mittelpunkts (PM) gleich oder größer als eine erste Schwellenspannung ist,
   wobei die Detektoranordnung (68) als Reaktion auf eine detektierte Fehlersituation dazu ausgelegt ist, die Zufuhr von Gleichstromleistung aus dem Sammelschienensystem (2) zumindest zu reduzieren, und
   wobei ein Verhältnis zwischen der ersten Schwellenspannung und einer Nennspannung des Ausgangs (42) des Gleichstromleistungsversorgungssystems (4) in einem Bereich von 1-10 % liegt.

2. Gleichstromleistungsversorgungsbaugruppe nach Anspruch 1, **dadurch gekennzeichnet, dass** die Detektoranordnung (68) als Reaktion auf die detektierte Fehlersituation dazu ausgelegt ist, die Zufuhr von Gleichstromleistung von dem Gleichstromleistungsversorgungssystem (4) zu dem Sammelschienensystem (2) zu stoppen.

3. Gleichstromleistungsversorgungsbaugruppe nach Anspruch 1 oder 2, **dadurch gekennzeichnet, dass** die Detektoranordnung (68) als Reaktion auf die detektierte Fehlersituation dazu ausgelegt ist, das Gleichstromleistungsversorgungs system (4) von dem Ausgang (22) des Sammelschienensystems (2) zu trennen.

4. Gleichstromleistungsversorgungsbaugruppe nach einem der vorhergehenden Ansprüche, **dadurch gekennzeichnet, dass** eine Nennspannung des Ausgangs (42) des Gleichstromleistungsversorgungssystems (4) gleich oder größer als 40 V ist.

5. Gleichstromleistungsversorgungsbaugruppe nach einem der vorhergehenden Ansprüche, **dadurch gekennzeichnet, dass** die erste Schwellenspannung in einem Bereich von 4-50 V liegt.

6. Gleichstromleistungsversorgungsbaugruppe nach einem der vorhergehenden Ansprüche, **dadurch gekennzeichnet, dass** der Spannungswert des Mittelpunkts (PM) aus einem Ausgangssignal der Spannungsmessanordnung (66) durch Signalverarbeitung durch die Detektoranordnung (68) erzeugt wird, wobei die Signalverarbeitung dazu ausgelegt ist, die Qualität der Fehlererkennung durch Filtern des Ausgangssignals der Spannungsmessanordnung (66) zu verbessern.

7. Gleichstromleistungsversorgungsbaugruppe nach einem der vorhergehenden Ansprüche, **dadurch gekennzeichnet, dass** ein Wert des hohen Widerstands, der durch die Widerstandsanordnung (64) zwischen dem Mittelpunkt (PM) und dem Massepotenzial bereitgestellt wird, eine Ungleichheit erfüllt

$$R_{mg} \geq \frac{U_{dc\_nom}}{0.001\,V/\Omega},$$

wobei $R_{mg}$ der Wert des hohen Widerstands ist und $U_{dc\_nom}$ ein Nennwert einer Ausgangsspannung an dem Ausgang (42) des Gleichstromleistungsversorgungssystems (4) ist.

8. Gleichstromleistungsversorgungsbaugruppe nach einem der vorhergehenden Ansprüche, **dadurch gekennzeichnet, dass** die Baugruppe zum Laden von Elektrofahrzeugen ausgelegt ist.

9. Gleichstromleistungsversorgungsbaugruppe nach einem der vorhergehenden Ansprüche, **dadurch gekennzeichnet, dass** der Ausgang (22) des Sammelschienensystems (2) eine temporäre Kopplungsvorrichtung, wie etwa einen Steckkontakt, umfasst.

**Revendications**

1. Ensemble d'alimentation en courant continu comprenant :

un système de barres omnibus (2) présentant une barre omnibus positive (BB+) et une barre omnibus négative (BB-), le système de barres omnibus (2) comprenant une sortie (22) adaptée à être connectée à une charge de l'ensemble ;
un système d'alimentation en courant continu (4) présentant une sortie (42) connectée au système de barres omnibus (2) ;
un système de détection de défauts (6) adapté à détecter des défauts à la terre dans l'ensemble d'alimentation en courant continu,
un agencement de condensateurs (62) comprenant un premier condensateur (C1) connecté entre la barre omnibus positive (BB+) et un point milieu (PM), et un deuxième condensateur (C2) connecté entre la barre omnibus négative (BB-) et le point milieu (PM) ; le système de détection de défauts (6) étant **caractérisé en ce qu'**il comprend en outre :

un agencement de résistances (64) fournissant une résistance élevée entre le point milieu (PM) et un potentiel de terre ;
un agencement de mesure de tension (66) destiné à mesurer une tension du point milieu (PM) par rapport au potentiel de terre ; et

un agencement détecteur (68) adapté à surveiller une valeur de tension du point milieu (PM), et à détecter une situation de défaut si des conditions de défaut prédéterminées relatives à la valeur de tension du point milieu (PM) sont remplies, les conditions de défaut prédéterminées comportant le fait que la valeur de tension du point milieu (PM) est supérieure ou égale à une première tension seuil,
dans lequel, en réponse à une situation de défaut détectée, l'agencement détecteur (68) est adapté à au moins réduire l'alimentation en courant continu à partir du système de barres omnibus (2), et
dans lequel un rapport entre la première tension seuil et une tension nominale de la sortie (42) du système d'alimentation en courant continu (4) est compris dans une plage de 1 à 10 %.

2. Ensemble d'alimentation en courant continu selon la revendication 1, **caractérisé en ce que**, en réponse à la situation de défaut détectée, l'agencement détecteur (68) est adapté à arrêter l'alimentation en courant continu du système de barres omnibus (2) à partir du système d'alimentation en courant continu (4).

3. Ensemble d'alimentation en courant continu selon la revendication 1 ou 2, **caractérisé en ce que**, en réponse à la situation de défaut détectée, l'agencement détecteur (68) est adapté à déconnecter le système d'alimentation en courant continu (4) de la sortie (22) du système de barres omnibus (2).

4. Ensemble d'alimentation en courant continu selon l'une quelconque des revendications précédentes, **caractérisé en ce qu'**une tension nominale de la sortie (42) du système d'alimentation en courant continu (4) est supérieure ou égale à 40 V.

5. Ensemble d'alimentation en courant continu selon l'une quelconque des revendications précédentes, **caractérisé en ce que** la première tension seuil est comprise dans une plage de 4 à 50 V.

6. Ensemble d'alimentation en courant continu selon l'une quelconque des revendications précédentes, **caractérisé en ce que** la valeur de tension du point milieu (PM) est générée à partir d'un signal de sortie de l'agencement de mesure de tension (66) au moyen d'un traitement de signal par l'agencement détecteur (68), le traitement de signal étant adapté à améliorer la qualité de la détection de défaut par filtrage du signal de sortie de l'agencement de mesure de tension (66).

**7.** Ensemble d'alimentation en courant continu selon l'une quelconque des revendications précédentes, **caractérisé en ce qu'**une valeur de la résistance élevée fournie par l'agencement de résistances (64) entre le point milieu (PM) et le potentiel de terre vérifie une inégalité

$$R_{mg} \geq \frac{U_{dc\_nom}}{0{,}001\ V/\Omega},$$

R$_{mg}$ représentant la valeur de la résistance élevée, et U$_{dc\_nom}$ représentant une valeur nominale d'une tension de sortie à la sortie (42) du système d'alimentation en courant continu (4).

**8.** Ensemble d'alimentation en courant continu selon l'une quelconque des revendications précédentes, l'ensemble étant **caractérisé en ce qu'**il est adapté à la charge de véhicules électriques.

**9.** Ensemble d'alimentation en courant continu selon l'une quelconque des revendications précédentes, **caractérisé en ce que** la sortie (22) du système de barres omnibus (2) comprend un dispositif de couplage temporaire tel qu'un contact enfichable.

Fig. 1

**EP 4 014 293 B1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20130272039 A1

**Non-patent literature cited in the description**

- **S. H. LEE** ; **K. S. LEE**. Proposal of DC Ground Fault Detection and Interruption Method in the Ungrounded Photovoltaic Array. *2019 IEEE 46th Photovoltaic Specialists Conference (PVSC-46)*